Europäisches Patentamt

European Patent Office

Office européen des brevets

(11) Veröffentlichungsnummer: **0 256 370**
**A1**

## (12) EUROPÄISCHE PATENTANMELDUNG

(21) Anmeldenummer: **87110942.7**

(51) Int. Cl.⁴: **G01N 24/04**

(22) Anmeldetag: **28.07.87**

(30) Priorität: **12.08.86 DE 3627293**

(43) Veröffentlichungstag der Anmeldung:
**24.02.88 Patentblatt 88/08**

(84) Benannte Vertragsstaaten:
**DE FR GB NL**

(71) Anmelder: **Siemens Aktiengesellschaft Berlin
und München**
**Wittelsbacherplatz 2**
**D-8000 München 2(DE)**

(72) Erfinder: **Zabel, Hans-Joachim**
**Freiburgerstr. 43**
**D-6900 Heidelberg(DE)**
Erfinder: **Lorenz, Walter, Prof. Dr.**
**Kastellweg 26**
**D-6900 Heidelberg(DE)**
Erfinder: **Bader, Reiner, Dr.**
**Gerhart-Hauptmann-Str. 18**
**D-6900 Heidelberg(DE)**

(54) **Antennenanordnung zur Anregung und Erfassung der kernmagnetischen Resonanz.**

(57) Bei der erfindungsgemäßen Antennenanordnung ist eine Antenne (1) über eine Zuleitung (2) mit einer Ankoppelschaltung (3) verbunden. Die Antennenanordnung ist auf mehrere Frequenzen einstellbar. Alle Frequenzen werden an einem gemeinsamen Punkt der Ankoppelschaltung (3) eingespeist. Die Zuleitung (2) wird bei jeder Frequenz auf die Leitungslänge $n \bullet \lambda/2$ abgestimmt und wirkt damit jeweils als Leitungsresonator. Die Abstimmung auf die Leitungslänge $n \bullet \lambda/2$ bei Änderung der Frequenz kann auf einfache Weise durch Zuschaltung eines Kondensators (8) erfolgen.

FIG 1

## Antennenanordnung zur Anregung und Erfassung der kernmagnetischen Resonanz

Die Erfindung betrifft eine Antennenanordnung zur Anregung und Erfassung der kernmagnetischen Resonanz für mehrere Frequenzen mit einer Ankoppelschaltung, wobei eine Zuleitung zwischen Ankoppelschaltung und Antenne bezüglich einer Frequenz mit der Wellenlänge λ -ggf. in Zusammenwirken mit einer Abstimmschaltung - auf die hochfrequenzmäßig wirksame Leitungslänge n•λ/2 abgestimmt ist.

Bei bildgebenden oder spektroskopischen Untersuchungen von Objekten mit Hilfe der kernmagnetischen Resonanz müssen diese mit einer für die untersuchte Kernart spezifischen Frequenz angeregt werden. In manchen Fällen ist es wünschenswert, verschiedene Kerne, z.B. Wasserstoff und Phosphor zu untersuchen. Dazu muß die von der Antennenanordnung gelieferte Frequenz veränderbar sein und es ändert sich entsprechend auch die empfangene Frequenz.

Herkömmliche Antennen, wie sie beispielsweise als Oberflächenspulen aus der WO 84/00214 bekannt sind, bestehen im wesentlichen aus einem Kondensator mit einstellbarer Kapazität und einer eine Induktivität bildenden Windung. Dabei wird der Kondensator so eingestellt, daß das Antennensystem bei der gewünschten Frequenz in Resonanz ist. Die Einstellbarkeit des Kondensators dient dabei lediglich dazu, die bei einer solchen Antenne sehr großen kapazitiven Einflüsse des Untersuchungsobjekts zu kompensieren. Eine Einstellbarkeit, die über diesen Bereich hinausgeht und eine Untersuchung verschiedener Kerne ermöglichen würde, ist mit diesem System in der Praxis nicht möglich. Die Güte des aus dem diskreten Kondensators und der Spule gebildeten Schwingkreises ist nämlich vom Verhältnis Induktivität zu Kapazität abhängig, so daß eine zu große Veränderung des Kondensators einen hohen Verlust an Schwingkreisgüte bedingen würde. Der wegen der kapazitiven Verstimmung dieser Antenne durch das Meßobjekt notwendige Abgleich erschwert die Handhabung und verlängert die Meßvorbereitungszeit.

Aus der EP-A-0 073 614 ist ein Antennensystem der eingangs genannten Art für zwei unterschiedliche Frequenzen bekannt. Dabei wird eine erste höhere Frequenz über eine erste Ankoppelschaltung mit einer Abgleicheinheit und eine Zuleitung an eine Antenne angekoppelt. Die Zuleitung hat dabei die Länge λ/2, wobei λ die Wellenlänge der ersten Frequenz ist. Die Zuleitung besitzt eine Anzapfung, in die über eine zweite Ankoppelschaltung mit einer zweiten Abgleicheinrichtung eine zweite niedrigere Frequenz eingespeist wird. Der Ankoppelpunkt wird dabei so gewählt, daß dabei die Hochfrequenz-Impedanz das Minimum aufweist. Die Ankoppelschaltungen sind so ausgeführt, daß die Einspeisungen für beide Frequenzen voneinander entkoppelt sind und somit beide Frequenzen gleichzeitig eingespeist werden können.

Bei dieser Antennenanordnung ist der Einspeisepunkt für die zweite, niedrigere Frequenz sehr kritisch, so daß sich im praktischen Aufbau erhebliche Probleme ergeben. Durch die Anzapfung der Leitung ist auch die höhere erste Frequenz festgelegt und kann nicht mehr verändert werden.

Aufgabe der Erfindung ist es daher, eine Antennenanordnung der eingangs genannten Art für mehrere Frequenzen so auszuführen, daß Aufbau und Umschaltung der Frequenzen vereinfacht werden und daß kapazitive Verstimmungen durch das Untersuchungsobjekt weitgehend vermieden werden.

Diese Aufgabe wird erfindungsgemäß dadurch gelöst, daß alle Frequenzen an einem gemeinsamen Punkt der Ankoppelschaltung eingespeist bzw. abgegriffen werden und daß die Zuleitung bei jeder Frequenz auf die Leitungslänge n•λ/2 abgestimmt wird und damit jeweils als Leitungsresonator wirkt. Damit kommt man mit einer einfachen Zuleitung ohne Anzapfung sowie einer einzigen Ankoppelschaltung aus. Die Umschaltung der Frequenzen kann auf einfache Weise in der Ankoppelschaltung erfolgen. Unterschiedliche Frequenzen können zwar nur nacheinander eingespeist bzw. erfaßt werden, was jedoch für die meisten Betriebsfälle ausreicht. Herkömmliche Resonanzkreise werden damit durch ein von kapazitiven Kopplungen weitgehend freies Antennensystem mit einem großen Frequenzbereich ersetzt.

Die Zuleitung kann am einfachsten als Koaxialleiter ausgeführt sein. Eine besonders einfache Möglichkeit der Frequenzumschaltung ergibt sich, wenn die Abstimmung der Leitungslänge auf n • λ/2 für eine geänderte Frequenz durch Zuschaltung eines Kondensators oder einer Drossel auf die Zuleitung in der Ankoppelschaltung erreicht wird. Der Kondensator kann dabei durch eine in Serie zu diesem liegende Schaltdiode geschaltet werden, wobei die Schaltdiode über einen Anschluß zur Zuschaltung des Kondensators mit Gleichstrom beaufschlagt wird.

Ein Feinabgleich der Antennenanordnung auf die jeweilige Frequenz kann vorteilhafter Weise durch eine zwischen der Zuleitung und Bezugspotential liegende Varaktordiode erfolgen, die über einen Anschluß mit Steuerspannung beaufschlagt wird.

Eine Optimierung der Leistungsausbeute der Hochfrequenzenergie erhält man, wenn in der Ankoppelschaltung zwischen die Zuleitung und Bezugspotential die Parallelschaltung einer Induktivität und einer Kapazität gelegt wird, wobei mit dieser Parallelschaltung der Blindwiderstand an dem der Antenne zugewandten Ende der Zuleitung kompensiert wird.

Die erfindungsgemäße Art der Frequenzabstimmung läßt sich dann besonders vorteilhaft einsetzen, wenn die Antenne durch ein zu einer Schleife geformtes Koaxialleiterstück gebildet wird, dessen Mantelabschirmung an einer Stelle eine Unterbrechung aufweist, wobei an einem Ende des Koaxialleiterstücks sowohl der Innenleiter als auch die Mantelabschirmung mit der Mantelabschirmung des anderen Endes des Koaxialleiterstückes elektrisch verbunden sind. Eine derartige Antenne weist eine besonders geringe kapazitive Kopplung zum Untersuchungsobjekt auf, so daß nur ein geringer Abgleichaufwand bei den einzelnen Frequenzen erforderlich ist.

Wenn die Zuleitung als Koaxialleitung ausgeführt ist, kann besonders vorteilhaft das schleifenförmige Koaxialleiterstück durch das Endstück der koaxialen Zuleitung gebildet werden.

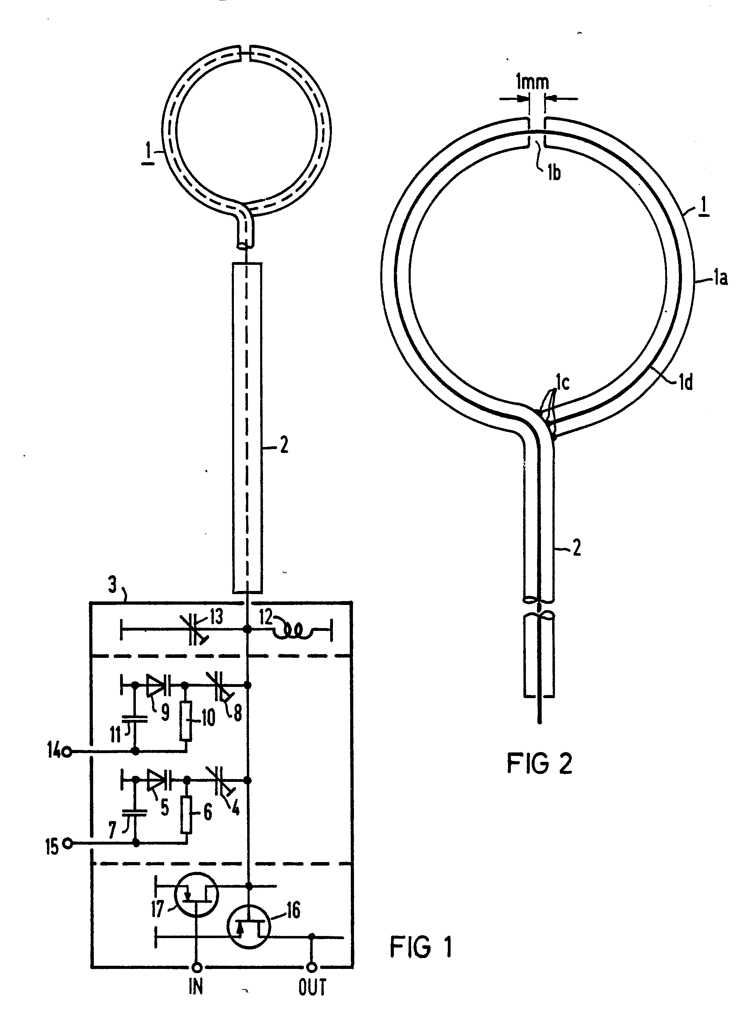

Ausführungsbeispiele der Erfindung werden nachfolgend anhand der Fig. 1 und 2 näher erläutert.

Fig. 1 zeigt das Prinzipschaltbild der Antennenanordnung. Dabei ist eine Antenne 1 über eine Zuleitung 2 an eine Ankoppelschaltung 3 angeschlossen. Die Ankoppelschaltung 3 enthält einen Feldeffekttransistor 16, der im Empfangsbetrieb als Vorverstärker wirkt und dessen Gate an die Zuleitung 2 angeschlossen ist. Für den Sendebetrieb ist ein Feldeffekttransistor 17 vorgesehen, dessen Drain-Source-Strecke an die Zuleitung 2 angeschlossen ist und an dessen Gate das Sendesignal ansteht. Zwischen der Zuleitung 2 und Bezugspotential liegt die Parallelschaltung eines einstellbaren Kondensators 13 und einer Drossel 12. Ferner ist zwischen die Zuleitung 2 und Bezugspotential die Reihenschaltung eines einstellbaren Kondensators 8 und einer Schaltdiode 9, z.B. einer PIN-Diode angeordnet. Ein Anschluß 14 ist über einen Kondensator 11 mit Bezugspotential und über einen Widerstand 10 mit dem Verbindungspunkt von Kondensator 8 und Schaltdiode 9 verbunden. Schließlich ist zwischen die Zuleitung 2 und Bezugspotential noch die Reihenschaltung eines einstellbaren Kondensators 4 und einer Varaktordiode 5 geschaltet. Ein Anschluß 15 ist über einen Kondensator 7 mit Bezugspotential und über einen Widerstand 6 mit dem Verbindungspunkt von Varaktordiode 5 und Kondensator 4 verbunden.

Solange die Eingangsklemme 14 nicht mit einem Gleichstrom beaufschlagt wird, sperrt die Diode 9 und der Kondensator 8 ist wirkungslos. In diesem Fall soll das System mit einer Frequenz f1 arbeiten. Die als Koaxialleiter ausgeführte Zuleitung 2 ist so abgestimmt, daß sie bei dieser Frequenz f1 möglichst exakt die Länge n•$\lambda$/2 hat. Ein Feinabgleich ist möglich, indem die Kapazität der Varaktordiode 5 durch eine Gleichspannung an der Eingangsklemme 15 entsprechend eingestellt wird. Der einstellbare Kondensator 4 dient dabei zum Grobabgleich. Mit dem Kondensator 7 soll lediglich die Auskopplung von Hochfrequenzen vermieden werden.

Die Zuleitung 2 wirkt somit in diesem Fall für die Frequenz f1 in Zusammenwirken mit den Kondensatoren 4 und 5 als $\lambda$/2-Leitungsresonator. Die Resonanzfrequenz ist im Gegensatz zu herkömmlichen Anordnungen mit diskreten LC-Schwingkreisen von der kapazitiven Kopplung mit dem Untersuchungsobjekt fast unabhängig, d.h. es tritt nur eine sehr geringe kapazitive Frequenzverstimmung auf. Damit kann die elektrische Abstimmung auf das Untersuchungsobjekt vermieden und die Meß-Vorbereitungszeit wesentlich verkürzt werden.

Durch den Kondensator 13 und die Drossel 12 wird der $\lambda$/2-Resonanzkreis an den Vorverstärker 16 bzw. 17 je nach Antenne 1 und Resonanzfrequenz soweit angepaßt, daß der Blindwiderstand am antennenseitigen Ende der Zuleitung 1 kompensiert ist.

Wenn nun die Antennenanordnung auf eine zweite Frequenz f2 umgeschaltet werden soll, so wird an den Anschluß 14 eine Gleichspannung angelegt, so daß die PIN-Diode 9 leitend und damit der Kondensator 8 wirksam wird. Damit wird die Zuleitung 2 soweit elektrisch verlängert, daß diese in Zusammenwirken mit dem Kondensator 8 für die neue Frequenz f2 wieder einen $\lambda$/2-Leitungsresonator bildet. Dabei wird die Güte des Leitungsresonators im Gegensatz zur herkömmlichen Anordnung kaum verändert. Die Abstimmung auf die neue Frequenz ist durch einfache Schaltungsmaßnahmen in der Ankoppeleinheit 3 möglich, wobei nur ein Vorverstärker 16 für beide Frequenzen erforderlich ist. In der Zuleitung 2 sind keinerlei mechanische Eingriffe notwendig. Damit wird die Antennenanordnung bei Anwendung als Oberflächenspule besonders einfach zu handhaben. Die Antennenanordnung kann für einen weiten Frequenzbereich eingesetzt werden, so daß Kerne mit unterschiedlicher Resonanzfrequenz mit einer einzigen Antennenanordnung untersucht werden können.

Fig. 2 zeigt eine Ausführung der Antenne 1, die sich in Verbindung mit dem beschriebenen $\lambda/2$-Leitungsresonator besonders gut eignet. Dabei ist das Endstück der koaxialen Verbindungsleitung 2 zu einer kreisförmigen Schleife gebogen und am Ende 1c dieser Schleife sind sowohl der Innenleiter 1d als auch die Mantelabschirmung 1a mit der Mantelabschirmung 1a am Anfangspunkt 1c der Schleife elektrisch verbunden. An einem dem Anfangspunkt 1c der Schleife gegenüberliegenden Punkt 1b weist die Mantelabschirmung 1a eine Unterbrechung auf.

Diese Anordnung wirkt als Rahmenantenne, die zur Vermeidung von Störungen mit einer an bevorzugter Stelle unterbrochenen koaxialen Abschirmung versehen ist. In diesem Fall ist die Antenne 1 Teil der Zuleitung 2.

Durch die Abschirmung wird die kapazitive Kopplung zum Meßobjekt auch für die Antenne selbst weitgehend vermieden. Die Antenne 1 ist sehr handlich bei der Anwendung und die approximative, kapazitive Abstimmung wird vermieden. Durch die Faraday'sche Wirkung der Mantelabschirmung bleibt die Antenne auch bei ungenügender Raumabschirmung von äußeren elektrischen Störstrahlungen unbeeinflußt. In Verbindung mit der Abstimmung als $\lambda/2$-Resonator entsteht somit eine von äußeren Einflüssen weitgehend unabhängige, einfach zu handhabende Antennenanordnung.

**Ansprüche**

1. Antennenanordnung zur Anregung und Erfassung der kernmagnetischen Resonanz für mehrere Frequenzen mit einer Ankoppelschaltung (3), wobei eine Zuleitung (2) zwischen Ankoppelschaltung (3) und Antenne (1) bezüglich einer Frequenz mit der Wellenlänge $\lambda$-ggf. im Zuammenwirken mit einer Abstimmschaltung (4,5) - auf die hochfrequenzmäßig wirksame Leitungslänge $n \bullet \lambda/2$ abgestimmt ist,
**dadurch gekennzeichnet,**
daß alle Frequenzen an einem gemeinsamen Punkt der Ankoppelschaltung (3) eingespeist bzw. abgegriffen werden und daß die Zuleitung (2) bei jeder Frequenz auf die Leitungslänge $n \bullet \lambda/2$ abgestimmt wird und damit jeweils als Leitungsresonator wirkt.

2. Antennenanordnung nach Anspruch 1,
**dadurch gekennzeichnet,**
daß die Zuleitung (2) als Koaxialleiter ausgeführt ist.

3. Antennenanordnung nach Anspruch 1 oder 2,
**dadurch gekennzeichnet,**
daß die Abstimmung der Leitungslänge auf $n \bullet \lambda/2$ für eine geänderte Frequenz durch Zuschaltung eines Kondensators (8) auf die Zuleitung (2) in der Ankoppelschaltung (3) erreicht wird.

4. Antennenanordnung nach Anspruch 1 oder 2,
**dadurch gekennzeichnet,**
daß die Abstimmung der Leitungslänge auf $n \bullet \lambda/2$ für eine geänderte Frequenz durch Zuschaltung einer Drossel auf die Zuleitung (2) in der Ankoppelschaltung (3) erreicht wird.

5. Antennenanordnung nach Anspruch 3,
**dadurch gekennzeichnet,**
daß der Kondensator (8) durch eine in Serie zu diesem liegende Schaltdiode (9) geschaltet wird, wobei die Schaltdiode (9) über einen Anschluß (14) zur Zuschaltung des Kondensators (8) mit Gleichstrom beaufschlagt wird.

6. Antennenanordnung nach einem der Ansprüche 1 bis 5,
**dadurch gekennzeichnet,**
daß ein Feinabgleich der Antennenanordnung auf die jeweilige Frequenz durch eine zwischen der Zuleitung (2) und Bezugspotential liegende Varaktordiode (5) erfolgt, die über einen Anschluß (15) mit einer Steuerspannung beaufschlagt wird.

7. Antennenanordnung nach einem der Ansprüche 1 bis 6,
**dadurch gekennzeichnet,**
daß in der Ankoppelschaltung (3) zwischen die Zuleitung (2) und Bezugspotential die Parallelschaltung einer Induktivität (12) und einer Kapazität (13) gelegt wird und daß mit dieser Parallelschaltung der Blindwiderstand an dem der Antenne (1) zugewandten Ende der Zuleitung (2) kompensiert wird.

8. Antennenanordnung nach einem der Ansprüche 1 bis 7,
**dadurch gekennzeichnet,**
daß die Antenne (1) durch ein zu einer Schleife geformtes Koaxialleiterstück gebildet wird, dessen Mantelabschirmung (1a) an einer Stelle (1b) eine Unterbrechung aufweist und daß an einem Ende (1c) des Koaxialleiterstücks sowohl der Innenleiter (1d) als auch die Mantelabschirmung (1a) mit der Mantelabschirmung des anderen Endes des Koaxialleiterstücks elektrisch verbunden sind.

9. Antennenanordnung nach Anspruch 2,
**dadurch gekennzeichnet,**
daß das schleifenförmige Koaxialleiterstück durch das Endstück der koaxialen Zuleitung (2) gebildet wird.

0 256 370

FIG 1

FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 160 942 (GENERAL ELECTRIC CO.) * Seite 17, Zeile 4 - Seite 18, Zeile 4; Abbildung 4b * | 1-3 | G 01 N 24/04 |
| A,D | EP-A-0 073 614 (MONSANTO CO.) * Seite 2, Zeile 2 - Seite 3, Zeile 24; Seite 5, Zeile 15 - Seite 6, Zeile 25; Abbildung 2 * | 1-4,6 | |
| A,D | WO-A-8 400 214 (OXFORD RESEARCH SYSTEMS LTD.) * Seite 2, Zeile 3 - Seite 6, Zeile 20; Seite 11, Zeilen 9-13; Seite 16, Zeile 12 - Seite 17, Zeile 7; Abbildungen 1-3 * | 1,2,8,9 | |
| A | EP-A-0 173 363 (N.V. PHILIPS' GLOEILAMPENFABRIEKEN) * Seite 9, Zeilen 1-27; Abbildungen 3-6 * | 1-3 | |
| A | EP-A-0 171 972 (PICKER INTERNATIONAL INC.) * Seite 4, Zeilen 8-23; Seite 8, Zeile 2 - Seite 9, Zeile 17; Abbildungen 4-6 * | 1,2 | **RECHERCHIERTE SACHGEBIETE (Int. Cl.4)** G 01 N H 01 Q H 03 J |
| A | US-A-4 095 168 (L.F. HLAVKA) * Spalte 1, Zeile 42 - Spalte 2, Zeile 21 * & DE-A-2 806 447 | 1,2 | |
| A | EP-A-0 145 915 (BRUKER MEDIZINTECHNIK GmbH) * Seite 10, Zeile 22 - Seite 11, Zeile 16; Seite 13, Zeile 3 - Seite 14, Zeile 28 * | | |

Der vorliegende Recherchenbericht wurde für alle Patentansprüche erstellt

| Recherchenort | Abschlußdatum der Recherche | Prüfer |
|---|---|---|
| DEN HAAG | 13-11-1987 | HORAK G.I. |